# EUROPÄISCHE PATENTSCHRIFT

(11) **EP 3 931 924 B1**
(45) Veröffentlichungstag und Bekanntmachung des Hinweises auf die Patenterteilung: **02.04.2025**
(21) Anmeldenummer: 20708415.3
(22) Anmeldetag: 13.02.2020
(51) Int. Cl.: H02B 1/30, H02B 1/32

(54) **SCHALTSCHRANKANORDNUNG MIT EINEM SCHALTSCHRANK UND MINDESTENS EINER STECKDOSENLEISTE**
ARRANGEMENT WITH AN ELECTRICAL ENCLOSURE AND AT LEAST ONE POWER STRIP
ASSEMBLAGE AVEC UNE ARMOIRE ÉLECTRIQUE ET AU MOINS UNE BARRE MULTIPRISE

(30) Priorität: 25.02.2019 DE 102019104723
(43) Veröffentlichungstag der Anmeldung: 05.01.2022
(73) Patentinhaber: Rittal GmbH & Co. KG, 35745 Herborn (DE)
(72) Erfinder: THIELMANN, Bodo, 35768 Siegbach (DE)
(74) Vertreter: Angerhausen, Christoph
(86) Internationale Anmeldenummer: PCT/DE2020/100097
(87) Internationale Veröffentlichungsnummer: WO 2020/173522

(56) Entgegenhaltungen:
- EP-A1- 2 608 645
- EP-B1- 2 608 645
- DE-A1- 102005 051 941
- US-A1- 2005 101 193
- US-A1- 2005 101 193
- US-A1- 2008 258 026
- US-A1- 2008 258 026
- US-A1- 2014 070 679
- US-A1- 2014 070 679
- US-B2- 7 535 696
- US-B2- 7 535 696

## Beschreibung

Die Erfindung geht aus von einer Schaltschrankanordnung mit mindestens einem Schaltschrank und mindestens einer Steckdosenleiste, wobei die Steckdosenleiste über einen Adapter mit einem ersten Adapterteil und einem zweiten Adapterteil an einem Vertikalprofil im Inneren des Schaltschranks festgelegt ist, wobei das erste Adapterteil an einer Befestigungsseite für die Montage des ersten Adapterteils an dem Vertikalprofil ein Formstück aufweist, über das das erste Adapterteil kraftschlüssig in einer Systemlochung des Vertikalprofils festgelegt ist. Eine derartige Schaltschrankanordnung ist aus der US 2008 258026 A1 bekannt. Ähnliche Anordnungen beschreiben auch die US 2014 070 679 A1, die US 7 535 696 B2, die DE 10 2004 007 260 B4, die DE 10 2014 100 417, die EP 2 608 645 A1 und die US 2005 101 193 A1.

Eine Befestigungsvorrichtung mit Einsteckhalter zum Anbringen von Flachteilen an Rahmenprofilen ist ferner aus der DE 10 2005 051 941 A1 offenbart.

Die aus dem Stand der Technik bekannten Schaltschrankanordnungen haben den Nachteil, dass die Adapter individuell für die jeweils vorgesehene Position innerhalb des Schaltschranks, an welcher die Steckdosenleiste im Schaltschrank montiert werden soll, angepasst sind, so dass im Anwendungsfall stets der passende Adapter beschafft werden muss, um die Steckdosenleiste an einer gewünschten Position im Schaltschrank zu montieren.

Es ist daher die Aufgabe der Erfindung, eine Schaltschrankanordnung der eingangs beschriebenen Art derart weiterzuentwickeln, dass der Adapter für eine flexible Montage der Steckdosenleiste im Inneren des Schaltschranks vorbereitet ist.

Diese Aufgabe wird durch eine Schaltschrankanordnung mit den Merkmalen des Anspruchs 1 gelöst. Die abhängigen Ansprüche betreffen jeweils vorteilhafte Ausführungsformen der Erfindung.

Demgemäß ist vorgesehen, dass das erste Adapterteil gegenüber von dem Form- und/oder Raststück eine Steckaufnahme für das zweite Adapterteil aufweist. So ist beispielsweise eine Ausführungsform denkbar, bei der das an der Steckdosenleiste montierte zweite Adapterteil ein Adapterteil ist, welches mit verschiedenen Ausführungsformen von ersten Adapterteilen für die hängende Montage der Steckdosenleiste an dem jeweiligen ersten Adapterteil vorbereitet ist. Mit Hilfe des einheitlichen zweiten Adapterteils kann die Steckdosenleiste damit an einer beliebigen Stelle im Schaltschrank, an welcher ein jeweiliges erste Adapterteil bereitgestellt ist, durch Einhängen in das zweite Adapterteil montiert werden.

Das zweite Adapterteil kann über eine lösbare Verbindung, vorzugsweise über eine Schraubverbindung an der Steckdosenleiste festgelegt sein. Das zweite Adapterteil kann weiterhin eine Nut-Feder-Verbindung aufweisen, über welche es an der Steckdosenleiste vorpositioniert ist. Die Schraubverbindung ist in diesem Fall zur Herstellung einer kraftschlüssigen Verbindung zwischen dem zweiten Adapterteil und der Steckdosenleiste vorgesehen.

Das erste Adapterteil kann eine Steckaufnahme, beispielsweise eine Rastaufnahme oder ein Schlüsselloch, und das zweite Adapterteil einen Pilzkopf aufweisen, der in die Steckaufnahme eingehängt ist. Dabei kann das zweite Adapterteil eine von der Steckdosenleiste abgewandte Anlageseite aufweisen, über die das zweite Adapterteil an dem ersten Adapterteil oder an dem Vertikalprofil anliegt. Der Pilzkopf kann einen Schaft aufweisen, mit dem er von der Anlageseite des zweiten Adapterteils absteht. Der Schaft kann über eine Rastverbindung in der Steckaufnahme arretiert sein. Dazu kann der Schaft beispielsweise an seinem Außenumfang eine unrunde Kontur aufweisen, die komplementär zu einer Kontur in der Steckaufnahme ist, wobei über die ineinandergreifenden Konturen eine Arretierung des Schafts in der Steckaufnahme erreicht wird.

Das zweite Adapterteil kann über einen Schraubbolzen an einer Rückseite der Steckdosenleiste befestigt sein. Der Schraubbolzen kann sich ausgehend von dem Pilzkopf durch den Pilzkopf und den Schaft hindurch bis in die Rückseite der Steckdosenleiste hinein erstrecken.

Das Form- und/oder Raststück kann ein Formstück aufweisen, das formschlüssig an einer Kontur eines Vertikalprofils eines Rahmengestells oder an einer Kontur einer Profilschiene anliegt, wobei das Formstück mindestens einen Rastvorsprung aufweist, über den das Form- und/oder Raststück in die Systemlochung des Vertikalprofils oder der Profilschiene eingreift und diese hintergreift.

Das erste Adapterteil kann an einer senkrecht zu der Befestigungsseite stehenden Stirnseite eine Anreihschnittstelle aufweisen. Über die Anreihschnittstelle kann ein Erweiterungsadapter mit einer zu der Anreihschnittstelle komplementären Schnittstelle festgelegt sein, wobei der Erweiterungsadapter ein drittes Adapterteil aufweist, über das eine weitere Steckdosenleiste über ein viertes Adapterteil festgelegt ist. Dabei kann das dritte Adapterteil identisch zu dem ersten Adapterteil und das vierte Adapterteil identisch zu dem zweiten Adapterteil sein.

Das erste Adapterteil und das dritte Adapterteil können jeweils eine Steckaufnahme und vorzugsweise dieselbe Steckaufnahme aufweisen, wobei die beiden Steckaufnahmen in derselben Ebene angeordnet sein können.

Das zweite Adapterteil kann über eine sich in Längsrichtung der Steckdosenleiste ersteckende Nut-Feder-Verbindung mit einer den Steckdosen der Steckdosenleiste zugewandten Rückseite der Steckdosenleiste verbunden sein.

Das erste Adapterteil kann eine Steckaufnahme, beispielsweise eine Rastaufnahme aufweisen, die zu einer Oberseite des ersten Adapterteils und zu einer dem zweiten Adapterteil zugewandten Vorderseite des ersten Adapterteils offen und nur in Richtung senkrecht zur Vorderseite hinterschnittig ausgebildet ist.

Weitere Einzelheiten der Erfindung werden anhand der nachstehenden Figuren erläutert. Dabei zeigt:
- Figur 1: in perspektivischer Darstellung eine erste Ausführungsform einer erfindungsgemäßen Schaltschrankanordnung;
- Figur 2: in perspektivischer Darstellung eine zweite Ausführungsform einer erfindungsgemäßen Schaltschrankanordnung;
- Figur 3: eine Ausführungsform einer Anordnung aus einer Steckdosenleiste sowie einem ersten und einem zweiten Adapterteil;
- Figur 4: die Ausführungsform gemäß Figur 3 mit Blick auf die Rückseite der Steckdosenleiste;
- Figur 5: eine weitere Ausführungsform einer Schaltschrankanordnung in perspektivischer Darstellung;
- Figur 6: eine Detailansicht eines ersten Adapterteils gemäß einer Ausführungsform der Erfindung;
- Figur 7: in perspektivischer Darstellung eine beispielhafte Ausführungsform eines zweiten Adapterteils;
- Figur 8: in perspektivischer Darstellung zwei Anordnungen aus mehreren aneinander angereihten zweiten Adapterteilen; und
- Figur 9: zwei weitere Ausführungsformen eines ersten Adapterteils sowie eines Erweiterungsadapters

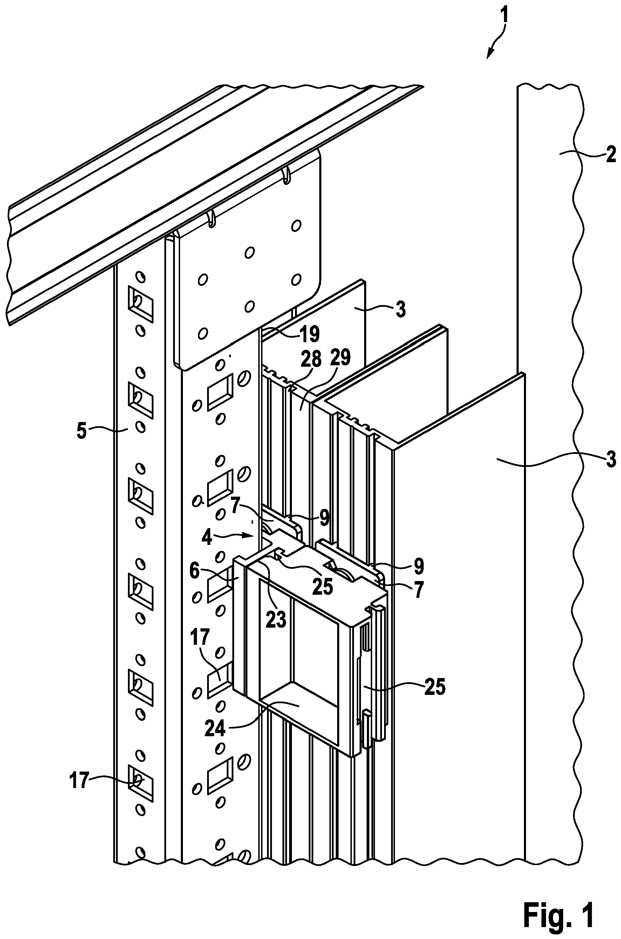

Die Figur 1 zeigt eine beispielhafte Ausführungsform einer Schaltschrankanordnung 1 mit einem Schaltschrank 2 und einer Steckdosenleiste 3, die über einen Einhängeadapter 4 an einem Vertikalprofil 5 des Schaltschranks 2 montiert ist. Das Vertikalprofil 5 ist vorliegend als eine 19"-Einbauschiene ausgebildet, wie sie in IT-Racks in das Rahmengestell des Schaltschranks 2 eingebaut werden, um das im IT-Bereich übliche 19"-Einbaumaß bereitzustellen. Das Vertikalprofil 5 ist über seine gegenüberliegenden Längsenden an einem Horizontalprofil des Rahmengestells des Schaltschranks 2 festgelegt.

Das Vertikalprofil 5 weist eine Kontur 19 auf, innerhalb welcher eine Steckdosenleiste mit Hilfe der erfindungsgemäßen Schaltschrankanordnung 1 platzsparend montiert werden kann. Dazu weist der Adapter 4 ein erstes Adapterteil 6 auf, welches in der Kontur 19 montiert ist und ein zweites Adapterteil 7, welches an einer Rückseite 29 über eine Nut-Feder-Verbindung 28 festgelegt ist.

Das erste Adapterteil 6 weist weiterhin eine Anreihschnittstelle 23 auf, über welche ein Erweiterungsadapter 24 mit einer komplementären Schnittstelle angesetzt ist. Analog zu dem ersten Adapterteil 6 weist auch der Erweiterungsadapter 24 an seiner den Steckdosenleisten 3 zugewandten Seite eine Schnittstelle in Form von Steckaufnahmen 9 auf, über welche die Steckdosenleisten 3 in das erste Adapterteil 6 beziehungsweise den Erweiterungsadapter 24 eingesteckt werden können. Der Erweiterungsadapter 24 weist an seiner von dem ersten Adapterteil 6 abgewandten Seite eine weitere komplementäre Anreihschnittstelle 25 für die Anreihung entweder eines weiteren Erweiterungsadapters 24 oder für die Anreihung eines ersten Adapterteils 6 auf. Der Erweiterungsadapter 24 kann somit in einer Richtung senkrecht zur Längsrichtung der Steckdosenleisten 3 symmetrisch ausgebildet sein.

Die zweiten Adapterteile 7 weiten einen Pilzkopf 10 (nicht erkennbar) auf, über den sie in die jeweilige Steckaufnahme 9 des ersten Adapterteils 6 beziehungsweise des Erweiterungsadapters 24 in Vertikalrichtung von oben eingehängt sind. Die Steckaufnahmen 9 können als Rastaufnahmen ausgebildet sein, so dass die Steckdosenleisten 3 nicht nur aufgrund ihres Eigengewichts in den Steckaufnahmen 9 gehalten sondern darüber hinaus auch gegenüber ungewolltem Herausfallen aus den Steckaufnahmen gesichert sind. Die Steckaufnahmen 9 weisen in Einsteckrichtung endseitig einen Anschlag für den Pilzkopf 10 auf, worüber in Vertikalrichtung nach unten eine definierte Endposition des Pilzkopfs 10 in der Steckaufnahmen 9 erreicht wird.

Zur Vereinfachung der Darstellung sind in sämtlichen Figuren die Steckdosenleisten 3 als U-förmige Gehäuse dargestellt.

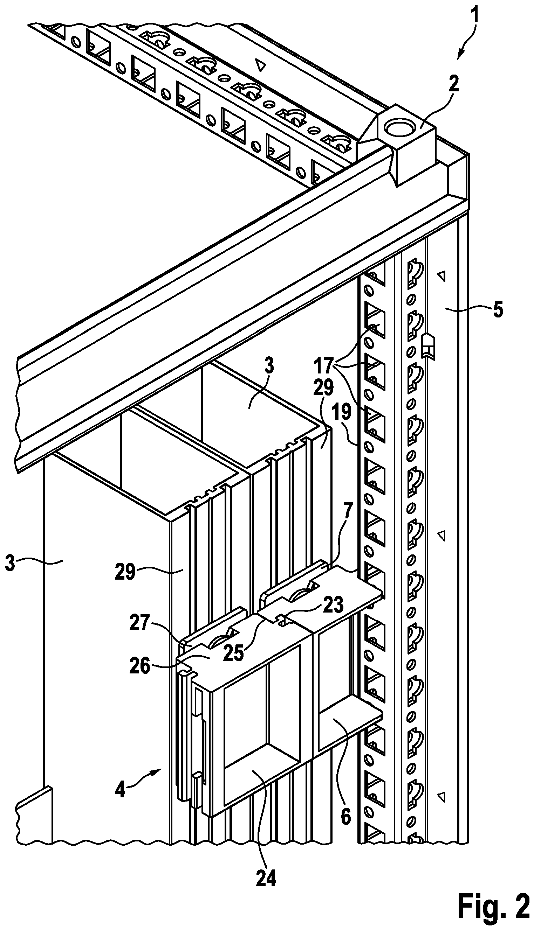

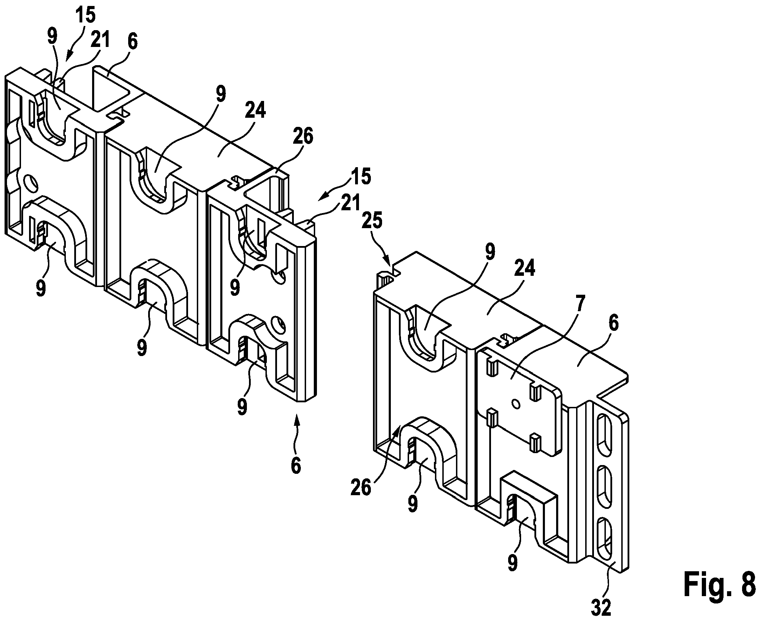

Die Figur 2 zeigt eine Abwandlung der Ausführungsform gemäß Figur 1, die sich insbesondere dadurch unterscheidet, dass die beiden Steckdosenleisten 3 unmittelbar am Rahmengestell des Schaltschranks 2, das heißt an einem Vertikalprofil des Rahmengestells 2 festgelegt sind. Während der Erweiterungsadapter 24 grundsätzlich identisch zu dem in Figur 1 gezeigten Erweiterungsadapter 24 ausgebildet sein kann, ist das erste Adapterteil 6 für die Montage an dem Vertikalprofil des Rahmengestells 2 ausgelegt. Dazu kann das erste Adapterteil 6 beispielsweise die Geometrie aufweisen, wie sie in Figur 8, rechts unten, gezeigt ist. Das erste Adapterteil 6 kann insbesondere einen Befestigungsflansch 32 aufweisen, über den das erste Adapterteil 6 über die Systemlochung des Vertikalprofils des Schaltschranks an dem Vertikalprofil verschraubt werden kann.

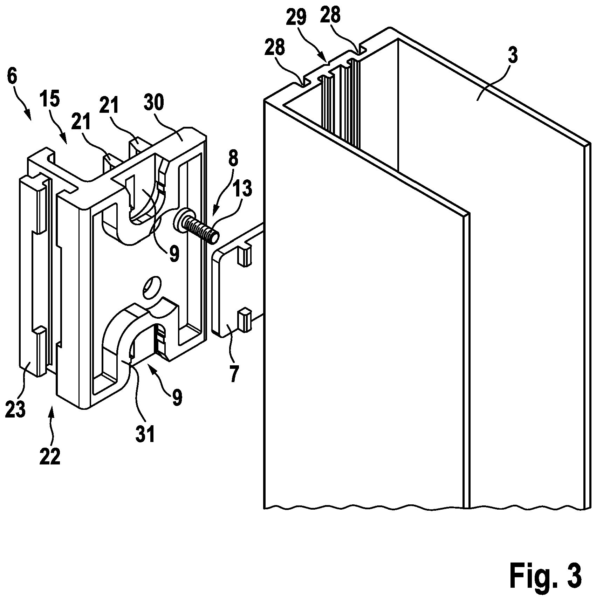

Die Figur 3 zeigt in einer Explosionsdarstellung das Zusammenwirken einer Steckdosenleiste 3 mit einem ersten und einem zweiten Adapterteil 6, 7. Das zweite Adapterteil 7 ist über eine lösbare Verbindung 8, die vorliegend als eine Schraubverbindung unter Zuhilfenahme eines Schraubbolzens 13 an der dem ersten Adapterteil 6 zugewandten Rückseite der Steckdosenleiste 3 verschraubt. An der Rückseite 29 weist die Steckdosenleiste 3 weiterhin zwei sich in Längsrichtung und über die gesamte Länge des dargestellten Steckdosengehäuses erstreckende Längsnuten 28 auf, über welche im Zusammenwirken mit entsprechenden Lageransätzen an der der Rückseite 29 zugewandten Seite des zweiten Adapterteils 7 eine Nut-Feder-Verbindung ausgebildet ist.

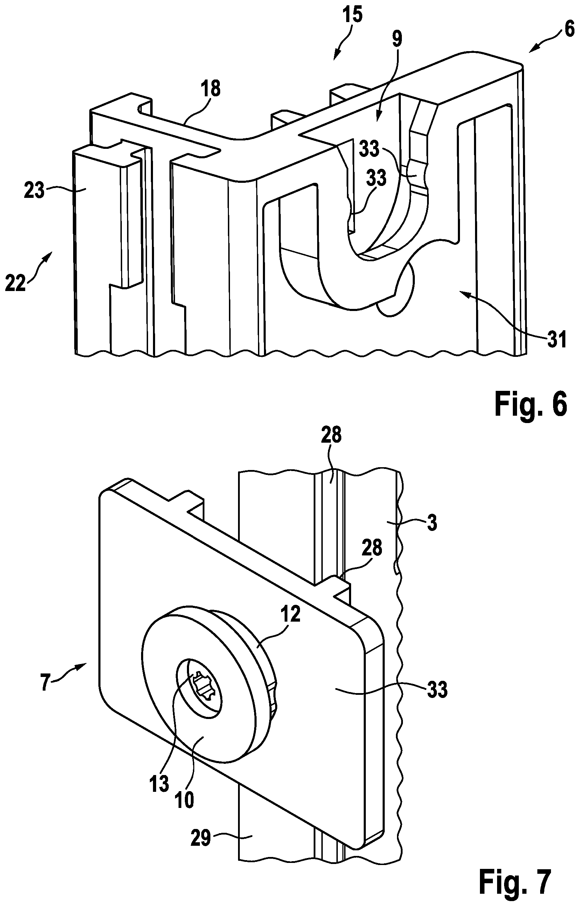

In der Zusammenschau mit Figur 7 ist zu erkennen, dass das zweite Adapterteil einen Pilzkopf 10 aufweisen kann, der über einen Schaft 12 an einer von der Rückseite 29 der Steckdosenleiste 3 abgewandten Seite des zweiten Adapterteils sich von dem zweiten Adapterteil 7 erstreckt, wobei der Pilzkopf 10 eine zentrale Durchgangsbohrung aufweist, über welche der Schraubbolzen 13 durch den Pilzkopf 10 und den Schaft 12 bis in die Rückseite 29 des Steckdosengehäuses 3 eingeschraubt werden kann.

Zurück zu Figur 3 ist zu erkennen, dass das erste Adapterteil 6 an seiner der Rückseite 29 zugewandten Vorderseite 31 in Längsrichtung der Steckdosenleiste 3 gegenüberliegend jeweils eine Steckaufnahme 9 aufweist, die als eine Rastaufnahme ausgebildet ist und zu jeweils einer von zwei gegenüberliegenden Oberseiten 30 des ersten Adapterteils 6 und zu einer dem zweiten Adapterteil 7 zugewandten Vorderseite 31 des ersten Adapterteils 6 offen ist. In der Richtung senkrecht zur Vorderseite 31 ist die Steckaufnahme 9 weiterhin hinterschnittig ausgebildet, um den Pilzkopf 10 (vgl. Figur 7) in der Steckaufnahme 9 zu halten.

Die Zusammenschau der Figuren 6 und 7 veranschaulicht weiterhin, dass wenn der Pilzkopf 10 mit dem Schaft 12 in die Steckaufnahme 9 eingesetzt ist, komplementäre Rastmittel 33 in der Steckaufnahme 9 beziehungsweise am Außenumfang des Schafts 12 ineinander greifen und somit eine Arretierung des zweiten Adapterteils 7 in der Rastaufnahme 9 des ersten Adapterteils erreicht wird.

Das erste Adapterteil 6 weist weiterhin an einer senkrecht zu der Befestigungsseite 15 stehenden Stirnseite 22 eine Anreihschnittstelle 23 auf. Über die Anreihschnittstelle 23 kann der Anreihadapter 24 (vgl. Fig. 1) mit einer zu der Anreihschnittstelle 23 komplementären Schnittstelle 25 festgelegt werden.

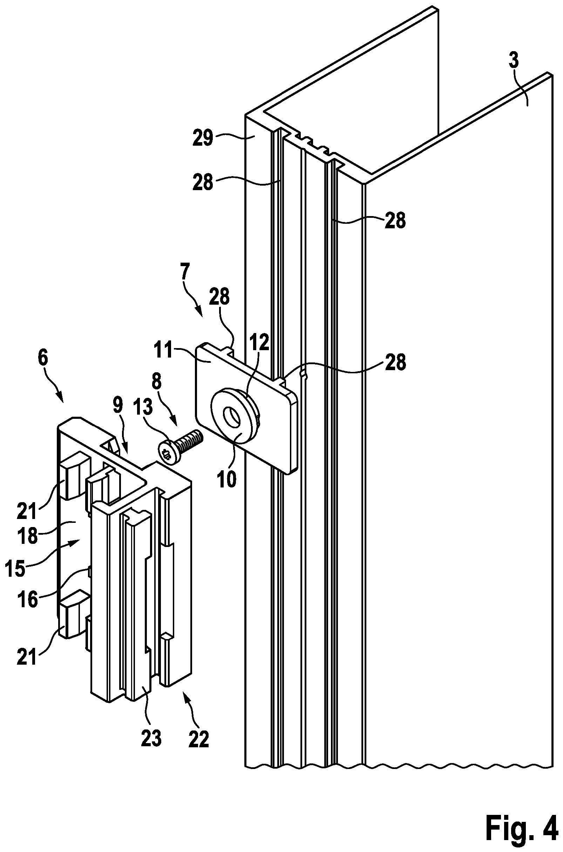

In der Darstellung gemäß Figur 4 ist die Anordnung gemäß Figur 3 mit Blick auf die Befestigungsseite 15 des ersten Adapterteils 6 gezeigt. Die Befestigungsseite 15 ist dem Vertikalprofil 5 (vgl. Figur 1) zugewandt und weist ein Form- und/oder Raststück 16 auf, dass sich bei der vorliegenden Ausführungsform aus einem Formstück 18 und Rastvorsprüngen 21 zusammensetzt. Das Formstück 18 ist dazu eingerichtet, eine Kontur 19 (vgl. Figur 1) des Vertikalprofils 5 zumindest abschnittsweise komplementär abzubilden, so dass zumindest abschnittsweise eine formschlüssige Anlage des ersten Adapterteils 6 über das Formstück 18 an dem Vertikalprofil 5 erreicht werden kann. Weiterhin erstrecken sich von dem Formstück 18 Rastmittel 21, die dazu eingerichtet sind, in eine Systemlochung 17 (siehe Figur 1) des Vertikalprofils 5 einzugreifen und diese zu hintergreifen, so dass auch eine kraftschlüssige Anbindung des ersten Adapterteils 6 an dem Vertikalprofil 5 erreicht werden kann.

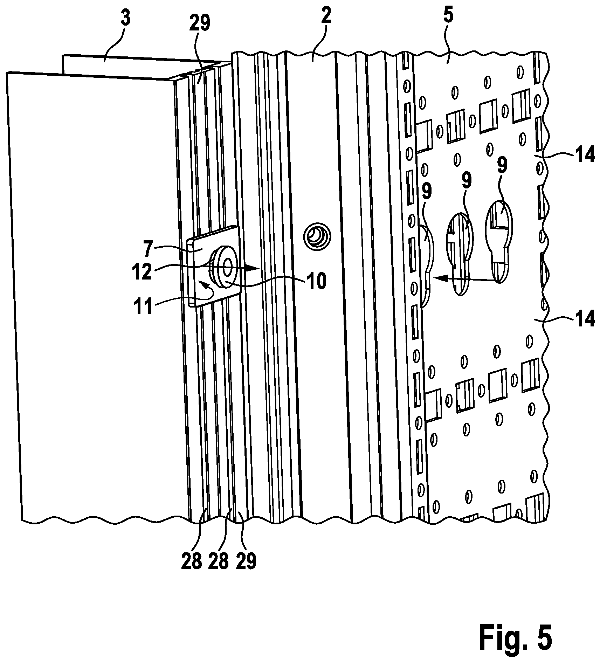

Die Figur 5 zeigt eine nicht beanspruchte Ausführungsform , bei der das erste Adapterteil in Form von schlüssellochförmigen Ausbrüchen in eine Montageseite 14 des Vertikalprofils 5 ausgebildet sind. Demgemäß bilden die schlüssellochförmigen Ausbrüche Steckaufnahmen 9, über die eine Steckdosenleiste 3, welche an ihrer Rückseite 29 ein zweites Adapterteil 7 aufweist, unmittelbar in das Vertikalprofil 5 eingehängt werden kann. Grundsätzlich kann vorgesehen sein, dass die in den Figur 1 bis 4 gezeigten Ausführungsformen mit der in Figur 5 gezeigten Ausführungsform kompatibel ist, zumindest insofern, als dass die in den unterschiedlichen Ausführungsformen gezeigten zweiten Adapterteile 7 identisch ausgebildet werden können. Dadurch wird eine hochflexible Montagemöglichkeit für die Steckdosenleisten im Inneren des Schaltschranks 2 erreicht.

Die Figur 8 zeigt verschiedene Anreihkombinationen erster Adapterteile 6 sowie Erweiterungsadapter 24. Bei der oben links gezeigten Ausführungsform sind zwei erste Adapterteile 6 über einen Erweiterungsadapter 24 miteinander verbunden. Sowohl die beiden ersten Adapterteile 6 als auch der Erweiterungsadapter 24 weisen Steckaufnahmen 9 auf, so dass die in Figur 8 oben links gezeigte Anordnung aus zwei ersten Adapterteilen 6 und einem Erweiterungsadapter 24 für die hängende Montage zweier nebeneinander angeordneter Steckdosenleisten eingerichtet ist. Des Weiteren ist diese Anordnung insoweit symmetrisch ausgebildet, als dass einerseits die Anordnung aus zwei ersten Adapterteilen 6 und einem Erweiterungsadapter 24 über wahlweise einen der beiden ersten Adapterteile 6 an einem Vertikalprofil montiert werden kann, beispielsweise an einem linken 19"-Vertikalprofil im Schaltschrank oder an einem rechten Vertikalprofil des Rahmengestells eines Schaltschranks. Darüber hinaus ist die Anordnung insofern symmetrisch ausgebildet, als dass die Einzelkomponenten 6, 24 an gegenüberliegenden Seiten jeweils eine Steckaufnahme 9 aufweisen, so dass die Anordnung auch in einer um 180° verdrehten Position wahlweise an einem linken und einem rechten Vertikalprofil montiert werden kann, und jeweils die erfindungsgemäße Funktionalität bereitstellt.

Bei der in Figur 8 unten rechts gezeigten Ausführungsform ist das erste Adapterteil 6 dazu eingerichtet, über seinen Befestigungsflansch 32 an einem Vertikalprofil eines Schaltschrankrahmengestells über dessen Systemlochung festgelegt zu werden.

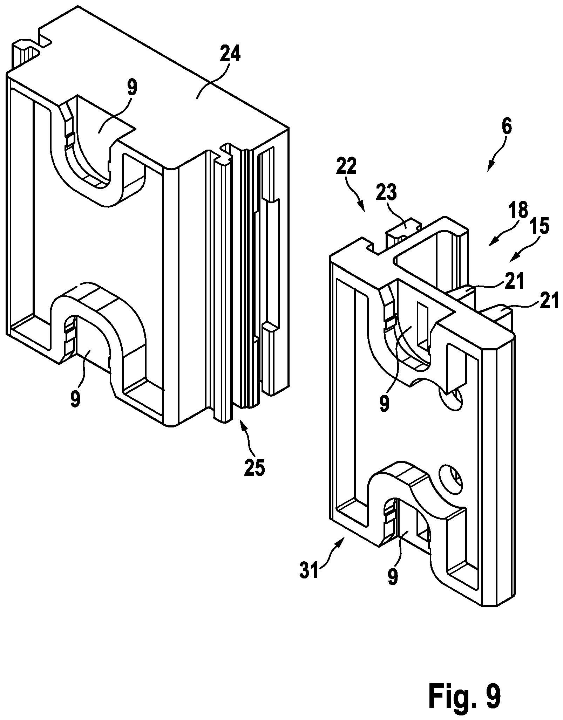

Weitere Einzelheiten des ersten Adapterteils 6 sowie des Erweiterungsadapters 24 sind in Figur 9 gezeigt. Die Ansicht gemäß Figur 9 zeigt insbesondere, dass eine Ausführungsform des ersten Adapterteils 6 drei funktionale Seiten aufweisen kann. An der Vorderseite 31 sind Steckaufnahmen 9 ausgebildet, welche einem zweiten Adapterteil zugewandt angeordnet werden können. Darüber hinaus weist das erste Adapterteil 6 an seiner der Vorderseite 31 gegenüberliegenden Befestigungsseite 15 ein Formstück 18 sowie Rastvorsprünge 21 für die Festlegung des ersten Adapterteils 6 an einem Vertikalprofil, beispielsweise an einer 19"-Einbauschiene auf. Senkrecht zu der Vorderseite 31 und der Befestigungsseite 25 ist die Stirnseite 22 des ersten Adapterteils 6 angeordnet, an welcher das erste Adapterteil 6 eine Anreihschnittstelle 23 für die Anreihung eines Erweiterungsadapters 24 aufweist. Der Erweiterungsadapter 24 weist demgemäß der Stirnseite 22 zugewandt eine komplementäre Schnittstelle 25 auf.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein. Der Schutzumfang der Erfindung ist in den beigefügten Ansprüchen definiert.

### Bezugszeichenliste

- 1: Schaltschrankanordnung
- 2: Schaltschrank
- 3: Steckdosenleiste
- 4: Adapter
- 5: Vertikalprofil
- 6: erstes Adapterteil
- 7: zweites Adapterteil
- 8: lösbare Verbindung
- 9: Steckaufnahme
- 10: Pilzkopf
- 11: Anlageseite
- 12: Schaft
- 13: Schraubbolzen
- 14: Montageseite
- 15: Befestigungsseite
- 16: Form- und/oder Raststück
- 17: Systemlochung
- 18: Formstück
- 19: Kontur
- 20: Rahmengestell
- 21: Rastvorsprung
- 22: Stirnseite
- 23: Anreihschnittstelle
- 24: Erweiterungsadapter
- 25: komplementäre Schnittstelle
- 26: drittes Adapterteil
- 27: viertes Adapterteil
- 28: Nut-Feder-Verbindung
- 29: Rückseite
- 30: Oberseite
- 31: Vorderseite
- 32: Befestigungsflansch
- 33: komplementäre Rastmittel

## Patentansprüche

1. Schaltschrankanordnung (1) mit mindestens einem Schaltschrank (2) und mindestens einer Steckdosenleiste (3), wobei die Steckdosenleiste (3) über einen Einhängeadapter (4) an einem Vertikalprofil (5) im Innern des Schaltschranks (2) festgelegt ist, der ein erstes Adapterteil (6) an dem Vertikalprofil (5) und ein zweites Adapterteil (7) an der Steckdosenleiste (3) aufweist, wobei die Steckdosenleiste (3) über das zweite Adapterteil (7) in das erste Adapterteil (6) an dem Vertikalprofil (5) eingehängt ist, wobei das erste Adapterteil (6) an einer Befestigungsseite (15) für die Montage des ersten Adapterteils (6) an dem Vertikalprofil (5) mindestens ein Form- und/oder Raststück (16) aufweist, über das das erste Adapterteil (6) form- und/oder kraftschlüssig in einer Systemlochung (17) des Vertikalprofils (5) festgelegt ist, wobei das erste Adapterteil (6) eine Vorderseite (31) mit einer Steckaufnahme (9) für das zweite Adapterteil (7) aufweist,
**dadurch gekennzeichnet, dass** das mindestens eine Form- und/ oder Raststück (16) gegenüber der Steckaufnahme (9) angeordnet ist.

2. Schaltschrankanordnung (1) nach Anspruch 1, bei der das zweite Adapterteil (7) über eine lösbare Verbindung (8), vorzugsweise über eine Schraubverbindung an der Steckdosenleiste (3) festgelegt ist.

3. Schaltschrankanordnung (1) nach Anspruch 1 oder 2, bei der die Steckaufnahme (9) eine Rastaufnahme oder ein Schlüsselloch ist, und das zweite Adapterteil (7) einen Pilzkopf (10) aufweist, der in die Steckaufnahme (9) eingehängt ist.

4. Schaltschrankanordnung (1) nach Anspruch 3, bei der das zweite Adapterteil (7) eine von der Steckdosenleiste (3) abgewandte Anlageseite (11) aufweist, über die das zweite Adapterteil (7) an dem ersten Adapterteil (6) oder an dem Vertikalprofil (5) anliegt, wobei der Pilzkopf (10) mit einem Schaft (12) von der Anlageseite (11) absteht, der über eine Rastverbindung in der Steckaufnahme (9) arretiert ist.

5. Schaltschrankanordnung (1) nach Anspruch 3, bei der das zweite Adapterteil (7) über einen Schraubbolzen (13) an einer Rückseite der Steckdosenleiste (3) befestigt ist, wobei sich der Schraubbolzen (13) ausgehend von dem Pilzkopf (10) durch den Pilzkopf (10) und den Schaft (12) hindurch bis in die Rückseite der Steckdosenleiste (3) hinein erstreckt.

6. Schaltschrankanordnung (1) nach Anspruch 1, bei der das Form- und/oder Raststück (16) ein Formstück (18) aufweist, das formschlüssig an einer Kontur (19) eines Vertikalprofils (5) eines Rahmengestells (20) oder an einer Kontur (19) einer Profilschiene anliegt, wobei das Formstück (18) mindestens einen Rastvorsprung (21) aufweist, über den das Form- und/oder Raststück (16) in die Systemlochung (17) des Vertikalprofils (5) oder der Profilschiene eingreift und diese hintergreift.

7. Schaltschrankanordnung (1) nach Anspruch 1, bei der das erste Adapterteil (6) an einer senkrecht zu der Befestigungsseite (15) stehenden Stirnseite (22) eine Anreihschnittstelle (23) aufweist.

8. Schaltschrankanordnung (1) nach Anspruch 7, bei der über die Anreihschnittstelle (23) ein Erweiterungsadapter (24) mit einer zu der Anreihschnittstelle (23) komplementären Schnittstelle (25) festgelegt ist, wobei der Erweiterungsadapter (24) ein drittes Adapterteil (26) aufweist, über das eine weitere Steckdosenleiste (3) über ein viertes Adapterteil (27) festgelegt ist.

9. Schaltschrankanordnung (1) nach Anspruch 8, bei der das dritte Adapterteil (26) identisch zu dem ersten Adapterteil (6) und das vierte Adapterteil (27) identisch zu dem zweiten Adapterteil (7) ist.

10. Schaltschrankanordnung (1) nach Anspruch 8 oder 9, bei der das erste Adapterteil (6) und das dritte Adapterteil (26) jeweils eine Steckaufnahme (9) und vorzugsweise dieselbe Steckaufnahme (9) aufweisen, wobei die beiden Steckaufnahmen (9) in derselben Ebene angeordnet sind.

11. Schaltschrankanordnung (1) nach einem der vorangegangenen Ansprüche, bei der das zweite Adapterteil (7) über eine sich in Längsrichtung der Steckdosenleiste (3) erstreckende Nut-Feder-Verbindung (28) mit einer den Steckdosen der Steckdosenleiste (3) abgewandten Rückseite (29) der Steckdosenleiste (3) verbunden ist.

12. Schaltschrankanordnung (1) nach einem der vorangegangenen Ansprüche, bei der das erste Adapterteil (6) eine Steckaufnahme (9), beispielsweise eine Rastaufnahme aufweist, die zu einer Oberseite (30) des ersten Adapterteils (6) und zu einer dem zweiten Adapterteil (7) zugewandten Vorderseite (31) des ersten Adapterteils (6) offen und nur in Richtung senkrecht zur Vorderseite (31) hinterschnittig ausgebildet ist.

## Claims

1. Switchgear cabinet arrangement (1) having at least one switchgear cabinet (2) and at least one socket strip (3), wherein the socket strip (3) is fixed via a suspension adapter (4) to a vertical profile (5) in the interior of the switchgear cabinet (2), which has a first adapter part (6) on the vertical profile (5) and a second adapter part (7) on the socket strip (3), wherein the socket strip (3) is suspended via the second adapter part (7) into the first adapter part (6) on the vertical profile (5), wherein the first adapter part (6) has, on a fastening side (15) for the mounting of the first adapter part (6) on the vertical profile (5), at least one form-fitting and/or latching piece (16), via which the first adapter part (6) is fixed in a form-fitting and/or force-fitting manner in a system hole (17) of the vertical profile (5), wherein the first adapter part (6) has a front side (31) with a plug-in receptacle (9) for the second adapter part (7), **characterized in that** the at least one form-fitting and/or latching piece (16) is arranged opposite the plug-in receptacle (9).

2. Switchgear cabinet arrangement (1) according to claim 1, in which the second adapter part (7) is fixed to the socket strip (3) via a releasable connection (8), preferably via a screw connection.

3. Switchgear cabinet arrangement (1) according to claim 1 or 2, in which the plug-in receptacle (9) is a latching receptacle or a keyhole, and the second adapter part (7) has a mushroom head (10), which is suspended into the plug-in receptacle (9).

4. Switchgear cabinet arrangement (1) according to claim 3, in which the second adapter part (7) has a contact side (11) facing away from the socket strip (3), via which the second adapter part (7) bears against the first adapter part (6) or against the vertical profile (5), wherein the mushroom head (10) projects with a shaft (12) from the contact side (11), which is locked in the plug-in receptacle (9) via a latching connection.

5. Switchgear cabinet arrangement (1) according to claim 3, in which the second adapter part (7) is fastened to a rear side of the socket strip (3) via a screw bolt (13), wherein the screw bolt (13) extends from the mushroom head (10) through the mushroom head (10) and the shaft (12) into the rear side of the socket strip (3).

6. Switchgear cabinet arrangement (1) according to claim 1, in which the shaped and/or latching piece (16) has a shaped piece (18), which bears in a form-fitting manner against a contour (19) of a vertical profile (5) of a frame (20) or against a contour (19) of a profile rail, wherein the shaped piece (18) has at least one latching projection (21), via which the shaped and/or latching piece (16) engages into the system hole (17) of the vertical profile (5) or of the profile rail and engages behind the latter.

7. Switchgear cabinet arrangement (1) according to claim 1, in which the first adapter part (6) has a line-up interface (23) on an end side (22) standing perpendicular to the fastening side (15).

8. Switchgear cabinet arrangement (1) according to claim 7, in which an expansion adapter (24) with an interface (25) complementary to the line-up interface (23) is fixed via the line-up interface (23), wherein the expansion adapter (24) has a third adapter part (26), via which a further socket strip (3) is fixed via a fourth adapter part (27).

9. Switchgear cabinet arrangement (1) according to claim 8, in which the third adapter part (26) is identical to the first adapter part (6) and the fourth adapter part (27) is identical to the second adapter part (7).

10. Switchgear cabinet arrangement (1) according to claim 8 or 9, in which the first adapter part (6) and the third adapter part (26) each have a plug-in receptacle (9) and preferably the same plug-in receptacle (9), wherein the two plug-in receptacles (9) are arranged in the same plane.

11. Switchgear cabinet arrangement (1) according to one of the preceding claims, in which the second adapter part (7) is connected via a tongue-and-groove connection (28) extending in the longitudinal direction of the socket strip (3) to a rear side (29) of the socket strip (3) facing away from the sockets of the socket strip (3).

12. Switchgear cabinet arrangement (1) according to one of the preceding claims, in which the first adapter part (6) has a plug-in receptacle (9), for example a latching receptacle, which is open to an upper side (30) of the first adapter part (6) and to a front side (31) of the first adapter part (6) facing the second adapter part (7) and is formed undercut only in the direction perpendicular to the front side (31).

## Revendications

1. Disposition d'armoire de commande (1) avec au moins une armoire de commande (2) et au moins une barre d'alimentation (3), dans laquelle la barre d'alimentation (3) est fixée par l'intermédiaire d'un adaptateur accroché (4) à un profilé vertical (5) à l'intérieur de l'armoire de commande (2), qui comprend une première partie d'adaptateur (6) sur le profilé vertical (5) et une deuxième partie d'adaptateur (7) sur la barre d'alimentation (3), dans laquelle la barre d'alimentation (3) est accrochée, par l'intermédiaire de la deuxième partie d'adaptateur (7), dans la première partie d'adaptateur (6) sur le profilé vertical (5), dans laquelle la première partie d'adaptateur (6) comprend, sur une face de fixation (15), pour le montage de la première partie d'adaptateur (6) sur le profilé vertical (5), au moins une pièce moulée et/ou une pièce d'encliquetage (16), par l'intermédiaire de laquelle la première partie d'adaptateur (6) est fixée, par complémentarité de forme et/ou par force, dans un système de perforations (17) du profilé vertical (5), dans laquelle la première partie d'adaptateur (6) présente une face avant (31) avec un logement d'enfichage (9) pour la deuxième partie d'adaptateur (7),
**caractérisée en ce que** l'au moins une pièce moulée et/ou d'encliquetage (16) est disposée en face du logement d'enfichage (9).

2. Disposition d'armoire de commande (1) selon la revendication 1, dans laquelle la deuxième partie d'adaptateur (7) est fixée à la barre d'alimentation (3) par l'intermédiaire d'une liaison amovible (8), de préférence par l'intermédiaire d'une liaison vissée.

3. Disposition d'armoire de commande (1) selon la revendication 1 ou 2, dans laquelle le logement d'enfichage (9) est un logement d'encliquetage ou un trou de serrure et la deuxième partie d'adaptateur (7) présente une tête de champignon (10) qui est accrochée dans le logement d'enfichage (9).

4. Disposition d'armoire de commande (1) selon la revendication 3, dans laquelle la deuxième partie d'adaptateur (7) présente une face d'appui (11) opposée à la barre d'alimentation (3), par l'intermédiaire de laquelle la deuxième partie d'adaptateur (7) s'appuie contre la première partie d'adaptateur (6) ou contre le profilé vertical (5), dans laquelle la tête de champignon (10) dépasse de la face d'appui (11) avec une tige (12) qui est bloquée dans le logement d'enfichage (9) par l'intermédiaire d'une liaison d'encliquetage.

5. Disposition d'armoire de commande (1) selon la revendication 3, dans laquelle la deuxième partie d'adaptateur (7) est fixée à une face arrière de la barre d'alimentation (3) par l'intermédiaire d'une tige vissée (13), dans laquelle la tige vissée (13) s'étend, à partir de la tête de champignon (10), à travers la tête de champignon (10) et de la tige (12), jusqu'à la face arrière de la barre d'alimentation (3).

6. Disposition d'armoire de commande (1) selon la revendication 1, dans laquelle la pièce moulée et/ou d'encliquetage (16) comprend une pièce moulée (18) qui s'appuie, par complémentarité de forme, contre un contour (19) d'un profilé vertical (5) d'un châssis (20) ou contre un contour (19) d'un rail profilé, dans laquelle la pièce moulée (18) présente au moins une saillie d'encliquetage (21), par l'intermédiaire de laquelle la pièce moulée et/ou d'encliquetage (16) s'emboîte dans le système de perforations (17) du profilé vertical (5) ou du rail profilé et s'accroche derrière celui-ci.

7. Disposition d'armoire de commande (1) selon la revendication 1, dans laquelle la première partie d'adaptateur (6) comprend, au niveau d'une face frontale (22) perpendiculaire à la face de fixation (15), une interface d'alignement (23).

8. Disposition d'armoire de commande (1) selon la revendication 7, dans laquelle l'interface d'alignement (23) permet de fixer un adaptateur d'extension (24) avec une interface (25) complémentaire de l'interface d'alignement (23), dans laquelle l'adaptateur d'extension (24) comprend une troisième partie d'adaptateur (26) par l'intermédiaire de laquelle une barre d'alignement (3) supplémentaire est fixée par l'intermédiaire d'une quatrième partie d'adaptateur (27).

9. Disposition d'armoire de commande (1) selon la revendication 8, dans laquelle la troisième partie d'adaptateur (26) est identique à la première partie d'adaptateur (6) et la quatrième partie d'adaptateur (27) est identique à la deuxième partie d'adaptateur (7).

10. Disposition d'armoire de commande (1) selon la revendication 8, dans laquelle la première partie d'adaptateur (6) et la troisième partie d'adaptateur (26) présentent chacune un logement d'enfichage (9) et de préférence le même logement d'enfichage (9), dans laquelle les deux logements d'enfichage (9) sont disposés sur le même plan.

11. Disposition d'armoire de commande (1) selon l'une des revendications précédentes, dans laquelle la deuxième partie d'adaptateur (7) est reliée, par l'intermédiaire d'une liaison par rainure et languette (28) s'étendant dans la direction longitudinale de la barre d'alimentation (3), avec une face arrière (29), opposée aux prises de la barre d'alimentation (3), de la barre d'alimentation (3).

12. Disposition d'armoire de commande (1) selon l'une des revendications précédentes, dans laquelle la première partie d'adaptateur (6) présente un logement d'enfichage (9), par exemple un logement d'encliquetage, qui est ouvert vers une face supérieure (30) de la première partie d'adaptateur (6) et vers une face avant (31) de la première partie d'adaptateur (6), orientée vers la deuxième partie d'adaptateur (7), et est réalisé avec une contre-dépouille uniquement dans la direction perpendiculaire à la face avant (31).
